# EUROPEAN PATENT APPLICATION

(11) **EP 4 243 220 A1**
(43) Date of publication of application: **13.09.2023**
(21) Application number: 21905260.2
(22) Date of filing: 15.10.2021
(51) Int. Cl.: H01R 13/52

(54) **ELECTRONIC DEVICE AND VEHICLE**

(30) Priority: 17.12.2020 CN 202011492038
(71) Applicant: Huawei Technologies Co., Ltd., Shenzhen, Guangdong 518129 (CN)
(72) Inventor: YIN, Jianqiang, Shenzhen, Guangdong 518129 (CN)
(74) Representative: Maiwald GmbH
(86) International application number: PCT/CN2021/124165
(87) International publication number: WO 2022/127331

(57) **Abstract**

An electronic device and a vehicle are disclosed. A protective cover (160) that can be opened and fastened is disposed on a housing (100) of the electronic device. A connector (130) that does not have waterproof performance is disposed inside the housing (100) of the electronic device. An external cable is connected to the connector (130) inside the housing (100), and then is led out from the housing (100) to outside of the housing (100). For ease of leading out a cable, at least one cable channel (180, 210) is provided on a fastening surface of the housing (100) and the protective cover (160), and housing sealing components such as a first sealing rubber strip (170) and a second sealing rubber strip (190) are further disposed around cable outlets (154, 166). When the protective cover (160) is fastened, the housing (100) and the protective cover (160) can press the first sealing rubber strip (170) tightly, to form sealing between the housing (100) and the protective cover (160). In addition, the first sealing rubber strip (170) and the second sealing rubber strip (190) can press a cable tightly, to form sealing between the cable and the housing (100) and between the cable and the protective cover (160). In this way, liquid, dust, and the like outside the housing (100) will not enter the housing (100), so that the electronic device can also have a waterproof capability and a dustproof capability when using a connector (130) that does not have waterproof performance.

## Description

This application claims priority to Chinese Patent Application No. 202011492038.7, filed with the China National Intellectual Property Administration on December 17, 2020 and entitled "ELECTRONIC DEVICE AND VEHICLE", which is incorporated herein by reference in its entirety.

### TECHNICAL FIELD

This application relates to a waterproof and dustproof structure, and in particular, to an electronic device and a vehicle that have a waterproof capability.

### BACKGROUND

A control system of an autonomous vehicle, especially a control system of a high-level autonomous vehicle, generally includes an in-vehicle computing module (or an automated driving computing platform), for example, a mobile data center (mobile data center, MDC). The in-vehicle computing module can sense a surrounding environment by using an in-vehicle sensor such as a camera, a laser radar, a millimeter-wave radar, and an ultrasonic wave, make a decision based on obtained information, and formulate a corresponding policy by using an appropriate working model, for example, predict a motion status of the vehicle, another vehicle, a pedestrian, or the like in a future time period, and perform collision avoidance path planning.

With the advancement of self-driving technologies, an autonomous driving level of a vehicle is continuously improved, and an in-vehicle computing module needs to implement more functions, requires an increasingly high computing power, and has an increasingly complex structure and an increasingly large size. Due to a limited space of a center console, a large-sized computing module can be installed only under a passenger compartment or in a front compartment of an engine, and operates in a relatively poor environment. Therefore, a waterproof level of the entire in-vehicle computing module needs to reach IPX7 or higher.

In a high-end autonomous vehicle, requirements for a communication rate and a bandwidth between each sensor and an in-vehicle computing module are increasingly high, and a low-speed connector cannot meet a communication requirement between the sensor and the in-vehicle computing module. Therefore, a high-speed connector needs to be configured for the in-vehicle computing module of the high-end autonomous vehicle. Currently, there is no mature solution to implementing a waterproof design that meets the IPX7 level between the high-speed connector and a housing of the in-vehicle computing module and between a male terminal and a female terminal of the high-speed connector.

### SUMMARY

Embodiments of this application provide an electronic device and a vehicle, to resolve a waterproof problem of an electronic device such as an in-vehicle computing module equipped with a high-speed connector.

According to a first aspect, an embodiment of this application provides an electronic device, including: a housing and a device mainboard, where the housing includes a first chamber and a second chamber, and the first chamber and the second chamber are disposed adjacently; the device mainboard is disposed in the first chamber, the device mainboard is provided with a connector, and the connector is configured to extend an end connected to an external cable from the first chamber to the second chamber; the housing includes a second chamber frame and a protective cover, where the protective cover is configured to be fastened on the second chamber frame; the second chamber frame is provided with a first sealing rubber strip; the protective cover includes a protective cover frame, and the protective cover frame is provided with a second sealing rubber strip; the first sealing rubber strip and the second sealing rubber strip are interconnected to form a cable channel used to lead out the external cable from the second chamber; and when the protective cover is fastened, the second chamber frame and the protective cover frame press the first sealing rubber strip to implement waterproof sealing between the second chamber frame and the protective cover frame, and the first sealing rubber strip and the second sealing rubber strip press the external cable in the cable channel to implement waterproof sealing between the external cable and the second chamber frame and between the external cable and the protective cover frame.

According to the electronic device provided in this embodiment of this application, the housing is provided with the protective cover that can be opened and fastened. In the electronic device, a connector that does not have waterproof performance is disposed inside the housing, and the external cable is connected to the connector inside the housing, and then is led out from the housing to outside of the housing. For ease of leading out a cable, at least one cable channel is provided on a fastening surface of the housing and the protective cover, and housing sealing components such as a first sealing rubber strip and a second sealing rubber strip are further disposed around a cable outlet. When the protective cover is fastened, the housing and the protective cover can press the first sealing rubber strip tightly, to form sealing between the housing and the protective cover. In addition, the first sealing rubber strip and the second sealing rubber strip can press a cable tightly, to form sealing between the cable and the housing and between the cable and the protective cover. In this way, liquid, dust, and the like outside the housing will not enter the housing, so that the electronic device can also have a waterproof capability and a dustproof capability when using a connector that does not have waterproof performance.

In an optional implementation, the second chamber frame includes a first frame top surface facing the protective cover, the first frame top surface is provided with a first groove and a second groove, the first groove is disposed around the second chamber in an annular manner, and the second groove is disposed on a path of the first groove and communicates with the second groove. In this way, the first groove and the second groove form a continuously closed annular structure on the first frame top surface, and a continuously closed first sealing rubber strip may be disposed, to facilitate sealing between a housing frame and the protective cover.

In an optional implementation, the first sealing rubber strip is of an annular structure and includes a first cable sealing part, and the first cable sealing part matches a structure of the second groove and is disposed in the second groove.

In an optional implementation, the first sealing rubber strip further includes a housing sealing part, and the housing sealing part matches a structure of the first groove and is disposed in the first groove.

In an optional implementation, the protective cover frame includes a second frame top surface facing the second chamber frame, the second frame top surface includes a third groove, and the third groove is disposed in correspondence with the second groove.

In an optional implementation, the second sealing rubber strip includes a second cable sealing part that is configured to be connected to the first cable sealing part, and the second cable sealing part matches a structure of the second groove and is disposed in the third groove.

In this way, because the second groove is disposed in correspondence with the third groove, after the protective cover is fastened, the first cable sealing part and the second cable sealing part may be interconnected, so as to facilitate sealing between the housing frame and the protective cover and clamp the external cable.

In an optional implementation, cable channels include a lower cable channel and an upper cable channel that are disposed through interconnection; the lower cable channel is disposed on the first frame top surface and a surface that is of the first cable sealing part and that faces the protective cover; and the upper cable channel is disposed on the second frame top surface and a surface that is of the second cable sealing part and that faces the second chamber frame. In this way, after the first cable sealing part and the second cable sealing part are interconnected, the lower cable channel and the upper cable channel can form a complete cable channel, so as to press the cable tightly, and form sealing between the cable and the housing and between the cable and the protective cover.

In an optional implementation, the lower cable channel sequentially includes a first internal cable outlet, a first cable trough, and a first external cable outlet along a lead-out direction of the external cable; the first internal cable outlet and the first external cable outlet are disposed on the first frame top surface, the first internal cable outlet extends from an inner wall of the second chamber frame to the second groove, and the first external cable outlet extends from the first groove to an outer wall of the second chamber frame; and the first cable trough is disposed on a surface that is of the first cable sealing part and that faces the protective cover, and extends from the first internal cable outlet to the first external cable outlet.

In an optional implementation, the upper cable channel sequentially includes a second internal cable outlet, a second cable trough, and a second external cable outlet along the lead-out direction of the external cable; the second internal cable outlet and the second external cable outlet are disposed on the second frame top surface, the second internal cable outlet extends from an inner wall of the protective cover frame to the third groove, and the second external cable outlet extends from an outer wall of the protective cover frame to the third groove; and the second cable trough is disposed on a surface that is of the second cable sealing part and that faces the second chamber frame, and extends from the second internal cable outlet to the second external cable outlet.

In an optional implementation, both the groove surface of the first cable trough and the groove surface of the second cable trough are semi-cylindrical surfaces. In this way, after the first cable trough and the second cable trough are interconnected, a complete cylindrical groove surface can be formed. The cylindrical groove surface may match a shape of the external cable, so that the cylindrical groove surface is closely attached to the external cable, and no gap is reserved, thereby improving sealing effect.

In an optional implementation, at least one first groove rib is disposed on the groove surface of the first cable trough, at least one second groove rib is disposed on the groove surface of the second cable trough, and the first cable trough and the second groove rib are perpendicular to the lead-out direction of the external cable; and a quantity of the first groove ribs is equal to a quantity of the second groove ribs, the first groove ribs and the second groove ribs are in a one-to-one correspondence, and the first groove rib and the second groove rib that have a correspondence are located in a same plane, and are configured to press the external cable from two directions, that is, an up direction and a down direction. In this way, each group of the first groove rib and the second groove rib that have a correspondence can press the external cable in two directions to form sealing, so that multi-layer sealing is formed, thereby enhancing a capability of preventing liquid from entering the housing from between the external cable and the first cable trough and from between the second cable trough.

In an optional implementation, a sealing ring for the external cable to pass through is disposed at one end that is of the first cable trough and that is close to the first internal cable outlet; and an annular groove for embedding the sealing ring is disposed at one end that is of the second cable trough and that is close to the second internal cable outlet, and a radius of the annular groove is less than or equal to an outer radius of the sealing ring. In this way, the sealing ring can be tightly attached to the annular groove under pressure between the first cable sealing part and the second cable sealing part, to form sealing, so as to prevent liquid from entering the housing from between the first cable sealing part and the second cable sealing part.

In an optional implementation, the first cable sealing part further includes first protruding parts, and the first protruding parts are located on a surface that is of the first cable sealing part and that faces the protective cover, and are distributed on two sides of the first cable trough; and each first protruding part extends from one end of the first cable sealing part to the other end of the first cable sealing part along the lead-out direction of the external cable.

In an optional implementation, the second cable sealing part further includes second protruding parts, and the second protruding parts are located on a surface that is of the second cable sealing part and that faces the second chamber frame, distributed on two sides of the second cable trough, and are disposed in correspondence with the second protruding parts; and each second protruding part extends from one end of the second cable sealing part to the other end of the second cable sealing part along the lead-out direction of the external cable.

In this way, when the protective cover is fastened, each group of the first protruding part 176 and the second protruding part that have a correspondence may be in contact with each other and squeeze each other, to produce deformation; and a pressure produced due to squeezing between the first protruding part and the second protruding part enables the first protruding part to be closely attached to the second protruding part, thereby improving a sealing effect at a junction between the first cable trough and the second cable trough.

In an optional implementation, the first sealing rubber strip further includes a cable channel sealing part; the cable channel sealing part includes an extension rubber strip and a sealing rubber plug; one end of the extension rubber strip is disposed on a side that is of the first cable sealing part and that faces the first external cable outlet, and the other end passes through the first external cable outlet and extends to outside of the housing; and the sealing rubber plug is of a cylindrical structure, and a circular bottom surface of the sealing rubber plug is connected to one end of the extension rubber strip located outside the housing. In this way, when no external cable is led out from the cable channel, the sealing rubber plug may be embedded into the cable channel to seal the cable channel, to from sealing, so as to prevent liquid from entering the housing from the cable channel.

According to a second aspect, an embodiment of this application provides a vehicle, including the electronic device according to any one of the first aspect or the implementations of the first aspect.

### BRIEF DESCRIPTION OF DRAWINGS

FIG. 1 is a schematic exploded view of a structure of an ECU equipped with a low-speed connector;
FIG. 2 is a schematic diagram of a current waterproof solution of an in-vehicle computing module equipped with a high-speed connector;
FIG. 3 shows an installation scenario of an in-vehicle computing module in a vehicle;
FIG. 4 is a schematic diagram of an electronic device according to an embodiment of this application;
FIG. 5 is a partial schematic diagram of a structure of a second chamber frame according to an embodiment of this application;
FIG. 6 is a schematic diagram of a structure of a first sealing rubber strip according to an embodiment of this application;
FIG. 7 is a schematic diagram of installing a first groove and a first sealing rubber strip according to an embodiment of this application;
FIG. 8 is a partial enlarged schematic diagram of a lower cable channel according to an embodiment of this application;
FIG. 9 is an A-direction sectional view after a first groove and a first sealing rubber strip are installed according to an embodiment of this application;
FIG. 10 is a schematic diagram of a structure of a protective cover according to an embodiment of this application;
FIG. 11 is a schematic diagram of a structure of a second sealing rubber strip according to an embodiment of this application;
FIG. 12 is a schematic diagram of installing a third groove and a second sealing rubber strip according to an embodiment of this application;
FIG. 13 is a partial schematic enlarged view of an upper cable channel according to an embodiment of this application;
FIG. 14 is a schematic diagram of connection between an electronic device and an external cable according to an embodiment of this application;
FIG. 15 is a schematic diagram of a fitting relationship between a housing, a protective cover, and a first sealing rubber strip when a protective cover 160 is fastened;
FIG. 16 is a diagram of a fitting relationship between a housing sealing part of a first sealing rubber strip, a first frame top surface, and a second frame top surface;
FIG. 17 is a diagram of a fitting relationship between a cable, a first cable sealing part, and a second cable sealing part when a protective cover is fastened;
FIG. 18 is a schematic diagram of fitting between a first protruding part and a second protruding part;
FIG. 19 is a schematic diagram of a structure of another first sealing rubber strip according to an embodiment of this application;
FIG. 20 is a schematic diagram of a manner of using a cable channel sealing part according to an embodiment of this application;
FIG. 21 is a schematic exploded view of a structure of a housing according to an embodiment of this application;
FIG. 22 is a schematic diagram of a structure of an upper housing according to an embodiment of this application;
FIG. 23 is a schematic diagram of installing an upper housing and a lower housing according to an embodiment of this application; and
FIG. 24 is a schematic diagram of a structure of an electronic device equipped with a low-speed connector according to an embodiment of this application.

In the figures:
100-Housing, 110-First chamber, 120-Second chamber, 130-Connector, 140-Second chamber bottom surface, 150-Second chamber frame, 151-First frame top surface, 152-First groove, 153-Second groove, 154-First internal cable outlet, 155-First external cable outlet, 156-First connection groove, 157-First positioning hole, 160-Protective cover, 161-Protective cover top surface, 162-Protective cover frame, 163-Second frame top surface, 164-Third groove, 165-Second connection groove, 166-Second internal cable outlet, 167-Second external cable outlet, 168-Second positioning hole, 170-First sealing rubber strip, 171-Housing sealing part, 172-First cable sealing part, 173-First cable trough, 174-First groove rib, 175-Sealing ring, 176-First protruding part, 177-First connection part, 178-Cable channel sealing part, 179-Extension rubber strip, 180-Lower cable channel, 181-Sealing rubber plug, 182-Arc-shaped structure, 190-Second sealing rubber strip, 191-Second cable sealing part, 192-Second connection part, 193-Second cable trough, 194-Second groove rib, 195-Annular groove, 196-Second protruding part, 200-Device mainboard, 210-Upper cable channel, 310-Cable body, 320-Wiring terminal, 410-Upper housing, 411-Upper housing top surface, 412-Upper housing frame, 413-Positioning groove, 414-Fifth frame top surface, 415-Second screw hole support, 416-Fourth positioning hole, 417-Connector opening, 420-Lower housing, 421-Lower housing bottom surface, 422-Lower housing frame, 423-Fourth frame top surface, 424-Fourth groove, 425-First screw hole support, 426-Third positioning hole, 427-Third sealing rubber strip, 428-Annular structure, and 510-connector.

### DESCRIPTION OF EMBODIMENTS

An autonomous vehicle (autonomous vehicle or self-piloting automobile), also referred to as an unmanned vehicle, a computer-driven vehicle, or a wheeled mobile robot, is an unmanned ground vehicle for transporting power. As an automated vehicle, the autonomous vehicle can sense an environment and navigation of the vehicle without human operation. The autonomous vehicle can sense the environment of the vehicle by using technologies such as a radar, an optical radar, a satellite navigation system (global navigation satellite system, GNSS), and computer vision. The control system of the autonomous vehicle can convert sensed data into appropriate navigation roads, obstacles, and related signs, so as to update map information, track a location of the vehicle in real time, and control or assist a driver in controlling vehicle driving behaviors in real time.

A control system of an autonomous vehicle, especially a control system of a high-level autonomous vehicle, generally includes an in-vehicle computing module (or an automated driving computing platform), for example, a mobile data center (mobile data center, MDC). The in-vehicle computing module can sense a surrounding environment by using an in-vehicle sensor such as a camera, a laser radar, a millimeter-wave radar, and an ultrasonic wave, make a decision based on obtained information, and formulate a corresponding policy by using an appropriate working model, for example, predict a motion status of the vehicle, another vehicle, a pedestrian, or the like in a future time period, and perform collision avoidance path planning.

In a daily driving process, a vehicle may face dust, rain, and foreign objects in a natural environment, or may travel on a wading road. Therefore, the in-vehicle computing module in the vehicle and another electrical device or unit (for example, an electronic control unit (electronic control unit, ECU) or a vehicle control unit (vehicle control unit, VCU)) that is used for vehicle control or data computing in the vehicle are usually required to have specific waterproof performance and dustproof performance.

The waterproof performance and dustproof performance are generally defined by an international protection level (International Protection Marking, IEC 60529), which is also known as an ingress protection level (Ingress Protection Rating) or an IP code (IP Code), and sometimes is known as a "waterproof level" or a "dustproof level". The International Protection Marking is a protection level standard developed by the International Electrotechnical Commission (International Electrotechnical Commission, IEC), and defines protection capabilities of mechanical and electronic devices against solid foreign objects (including a body part such as a finger, dust, sand, and the like), liquid infiltration, and accidental touch.

The international protection level is represented by an IP code. The IP code includes an IP address and two numbers, for example, IP54 and IP68. The first number indicates a solid particle protection level (dustproof level), the second number indicates a liquid infiltration protection level (waterproof level), and a larger value indicates a higher protection level. The two numbers are integers ranging from 1 to 9. In some cases, the two numbers can also be letters X, indicating that the information about preventing foreign objects or dust is not provided. For example, IPX7 indicates that the internal components of the device can be protected for at least 30 minutes when the device is immersed in water less than 1 m deep, but no information about dust prevention is provided. In addition, an English letter may be added after the two numbers in the IP code to indicate another protection capability. For example, "9K" in "IPX9K" indicates a protection capability of the device against a high-temperature and high-pressure water column. Specifically, 9K indicates that the device can withstand impact of the high-temperature and high-pressure water column for at least two minutes under a condition specified by a manufacturer.

The IP protection levels of devices such as an in-vehicle computing module, an ECU, and a VCU in the vehicle can be determined based on installation positions of the devices. For example, when the device is installed in a position with a relatively good environment, such as a cockpit, a requirement for an IP protection level is relatively low, for example, a waterproof level is at least IPX2; or when the device is installed in a position with a relatively poor environment, such as a vehicle bottom or a cockpit, a requirement for an IP protection level is relatively high, for example, a waterproof level is at least IPX7 or IPX9K.

In a device such as an in-vehicle computing module, an in-vehicle connector is configured to connect the device to an external cable, to implement communication between the device and another device connected to the other end of the cable. Vehicle connectors are classified into low-speed connectors and high-speed connectors according to different communication rates supported by the vehicle connectors.

A conventional non-autonomous vehicle generally includes only a device such as an in-vehicle computing module or an ECU that has a low computing power. Such a device has a relatively simple structure and a small size, and may be installed in a center console of the vehicle. Therefore, a requirement on a waterproof level of the device is relatively low, and generally, only an IPX2 level needs to be met. Generally, waterproofing of devices such as the in-vehicle computing module and the ECU mainly includes waterproofing of a device housing, waterproofing between the device housing and the in-vehicle connector, and waterproofing between the in-vehicle connector and a cable.

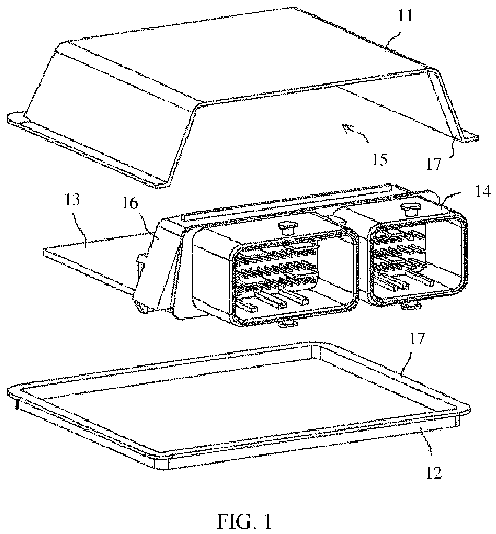

In a conventional non-autonomous vehicle, a device such as an in-vehicle computing module or an ECU is usually equipped with a low-speed connector. FIG. 1 is a schematic exploded view of a structure of an ECU equipped with a low-speed connector. As shown in FIG. 1, the ECU includes an upper housing 11, a lower housing 12, a printed circuit board (printed circuit board, PCB) 13, and a low-speed connector 14. After being fastened, the upper housing 11 and the lower housing 12 can form an opening 15 for accommodating the low-speed connector 14. The low-speed connector 14 is disposed at the opening 15 of the housing, one end of the low-speed connector 14 is connected to the PCB 13 in the housing, and the other end is located outside the housing and configured to connect to a cable. The low-speed connector 14 is provided with a base 16 that matches a shape of the opening. When the ECU housing is fastened, an upper housing 11 and a lower housing 12 may be sealed through glue dispensing 17, and the housing and the low-speed connector 14 may be sealed through glue dispensing 17 on a connection surface between the opening 15 and the base 16, so as to meet a waterproof requirement of the entire device. The technical solution is relatively mature.

However, with the advancement of self-driving technologies, an autonomous driving level of a vehicle is continuously improved, and an in-vehicle computing module needs to implement more functions, requires an increasingly high computing power, and has an increasingly complex structure and an increasingly large size. Due to a limited space of a center console, a large-sized computing module can be installed only under a passenger compartment or in a front compartment of an engine, and operates in a relatively poor environment. Therefore, a waterproof level of the entire in-vehicle computing module needs to reach IPX7 or higher.

In addition, in a high-end autonomous vehicle, requirements for a communication rate and a bandwidth between each sensor and an in-vehicle computing module are increasingly high, and a low-speed connector cannot meet a communication requirement between the sensor and the in-vehicle computing module. Therefore, a high-speed connector needs to be configured for the in-vehicle computing module of the high-end autonomous vehicle. Currently, there is no mature solution to implementing a waterproof design that meets the IPX7 level between the high-speed connector and a housing of the in-vehicle computing module and between a male terminal and a female terminal of the high-speed connector.

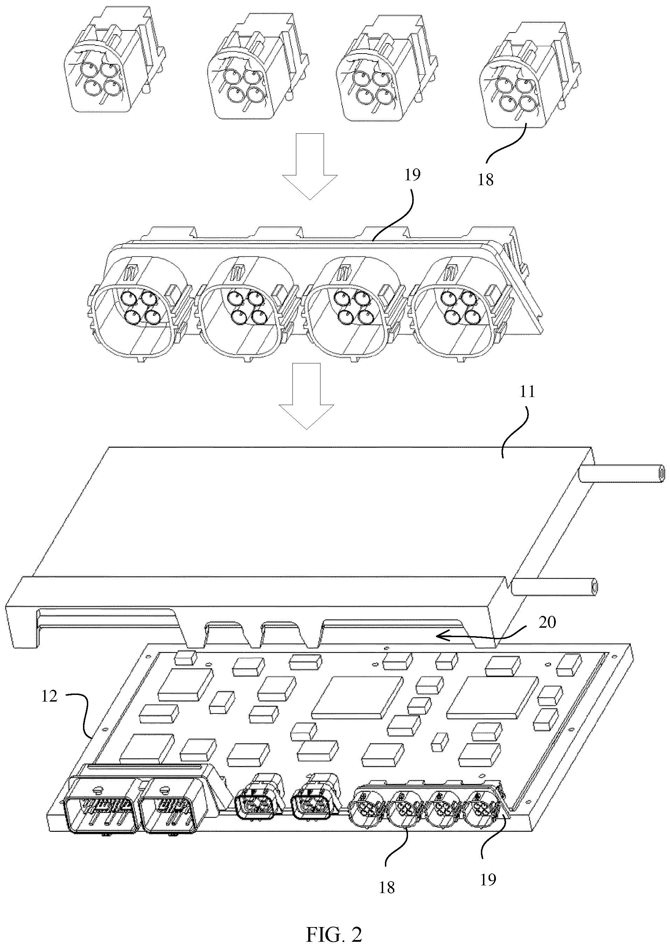

FIG. 2 is a schematic diagram of a current waterproof solution of an in-vehicle computing module equipped with a high-speed connector. As shown in FIG. 2, a plurality of high-speed connectors 18 may be jointly disposed on a base 19 in a customized design manner. After being fastened, an upper housing 11 and a lower housing 12 of the in-vehicle computing module may form an opening 20 that matches a size and a shape of the base 19, so that the base 19 may be disposed in the opening 20. A joint between the upper housing 11 and the lower housing 12, a joint between the base 19 and the upper housing 11, and a joint between the base 19 and the lower housing 12 may be sealed through glue dispensing, so as to provide a waterproof capability.

However, the waterproof solution in which a customized high-speed connector is combined with a waterproof sealant shown in FIG. 2 has at least the following technical problems in actual application: 1. The in-vehicle computing module needs to use a customized high-speed connector, and cannot use a connector that meets an industry standard structure, and therefore has poor universality. 2. The waterproof sealant is used to connect housings, which makes it difficult to disassemble the housing. In a disassembling process, a device mainboard 200 may be easily damaged. In addition, once the housing is disassembled, the waterproof structure is damaged and is difficult to recover. 3. The customized high-speed connector occupies a larger space, and increases a size of the in-vehicle computing module, which is not conducive to installation on a vehicle.

To resolve the foregoing problem, an embodiment of this application provides an electronic device. The electronic device may be, for example, an in-vehicle computing module, an ECU, a VCU, or another device. The electronic device can have a waterproof capability of the IPX7 level when a high-speed connector of a standard structure is used.

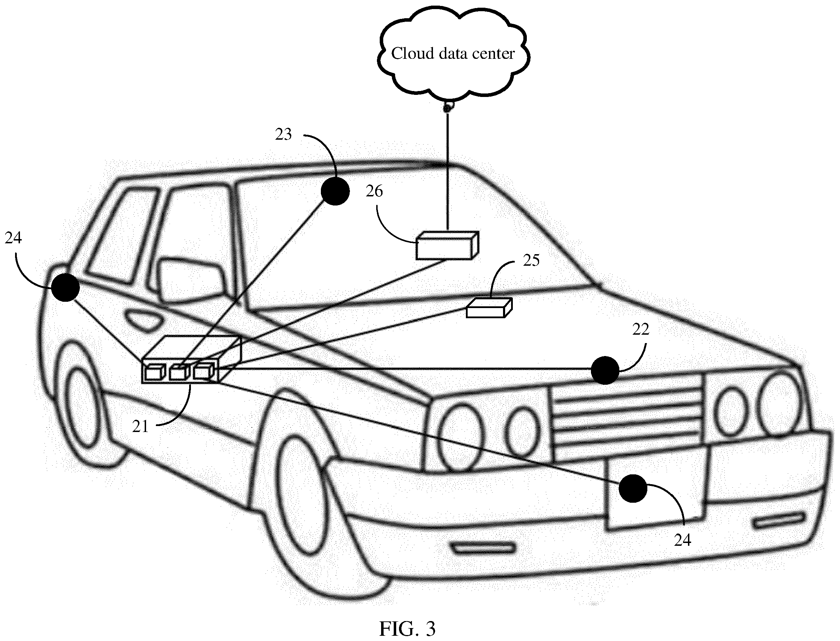

To help a person skilled in the art to have a deep understanding of the technical solution of this application, FIG. 3 shows an installation scenario of an in-vehicle computing module in a vehicle. As shown in FIG. 3, the in-vehicle computing module 21 is generally installed in a vehicle body, for example, in a center console, under a seat, or in an engine compartment. To collaborate with the in-vehicle computing module 21, various types of sensors, such as a laser radar 22, a camera 23, and a millimeter-wave radar 24, are further installed on the vehicle, to detect an environment in which the vehicle is located, a status of the vehicle, and the like, and feed back detected data to the in-vehicle computing module 21. The in-vehicle computing module 21 performs an inference operation on the received data in real time by using a built-in artificial intelligence (artificial intelligence, AI) chip, for example, a neural-network processing unit (neural-network processing unit, NPU), and generates an operation instruction according to an operation result and delivers the operation instruction to a vehicle control unit (vehicle control unit, VCU) 25. The VCU controls vehicle braking, for example, braking and deceleration, according to the operation instruction, to implement various levels of self-driving functions. The computing module may further upload data to a cloud data center at the back end of a network by using an in-vehicle communication terminal (telematics box, T-BOX) 26. Generally, information may be transmitted between the in-vehicle computing module 21 and the camera 23 by using a gigabit multimedia serial link (gigabit multimedia serial link, GMSL); information may be transmitted between the in-vehicle computing module 21 and the laser radar 22 by using an in-vehicle Ethernet link; information may be transmitted between the in-vehicle computing module 21 and the VCU 25 or between the motor control unit (motor control unit, MCU) and a battery management system (battery management system, BMS) by using a controller area network (controller area network, CAN) bus; information may be transmitted between the in-vehicle computing module 21 and the millimeter-wave radar 24 by using a CAN bus; information may be transmitted between the in-vehicle computing module 21 and an ultrasonic radar (not shown in FIG. 2) by using a local Internet (local interconnect network, LIN) bus; and information may be transmitted between the in-vehicle computing module 21 and the T-BOX 26 by using an Ethernet link.

The following describes a specific structure of an electronic device according to an embodiment of this application by using the in-vehicle computing module as an example.

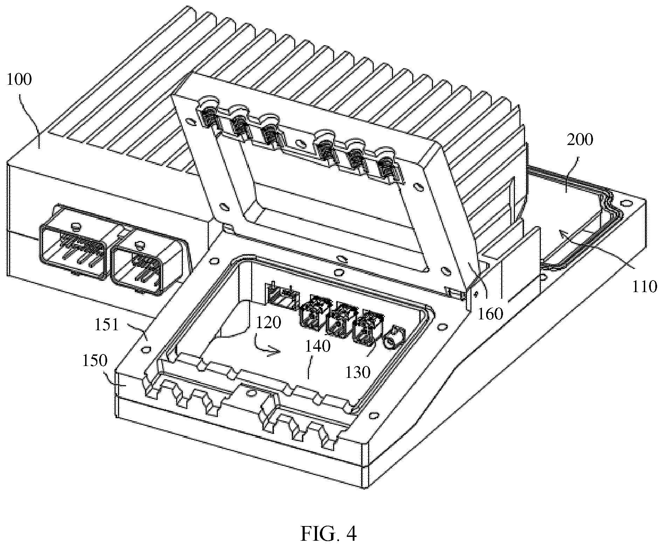

FIG. 4 is a schematic diagram of an electronic device according to an embodiment of this application. As shown in FIG. 4, the electronic device includes a housing 100 and a device mainboard 200. For ease of describing an internal structure of the electronic device, the housing 100 is cut in FIG. 4. The housing 100 includes a first chamber 110 and a second chamber 120 that are configured to accommodate internal components of the electronic device. The second chamber 120 is located on one side of the first chamber 110, and is disposed adjacent to the first chamber 110. The first chamber 110 and the second chamber 120 communicate with each other.

The device mainboard 200 is disposed in the first chamber 110. At least one connector 130 is disposed on the device mainboard 200, where the at least one connector 130 may be disposed in parallel at a position that is of the device mainboard 200 and that is close to the second chamber 120. In addition, one end that is of the at least one connector 130 and that is used to connect to an external cable extends from the first chamber 110 to the second chamber 120.

The connector 130 in this embodiment of this application may be a high-speed connector, or may be a low-speed connector, preferably a high-speed connector. Generally, a low-speed connector usually has waterproof performance because of early emergence of the technology and a long development time, and a high-speed connector do not have waterproof performance because of late emergence of the technology and a short development time. In other words, the connector 130 in this embodiment of this application may be a connector having waterproof performance and a connector that does not have waterproof performance.

Further, as shown in FIG. 4, an area of the housing 100 in the second chamber 120 includes a second chamber bottom surface 140, a second chamber frame 150, and a protective cover 160. The second chamber frame 150 is disposed around the second chamber bottom surface 140, and the second chamber frame 150 has a specific height in a direction perpendicular to the second chamber bottom surface 140, to form a part of a depth of the second chamber 120. The protective cover 160 is configured to be fastened on the second chamber frame 150, so as to seal the second chamber 120. The second chamber frame 150 has a specific width in the direction parallel to the second chamber bottom surface 140. Therefore, the second chamber frame 150 can form, at an end facing the protective cover 160, a first frame top surface 151 having a specific width.

The first frame top surface 151 is an annular top surface. The first frame top surface 151 may have different shapes, depending on a shape of the second chamber 120. For example, when the second chamber 120 is a rectangular chamber, the first frame top surface 151 is a rectangular annular top surface; or when the second chamber 120 is a circular chamber, the first frame top surface 151 may be a circular annular top surface. Therefore, the shape of the first frame top surface 151 is not specifically limited in this embodiment of this application.

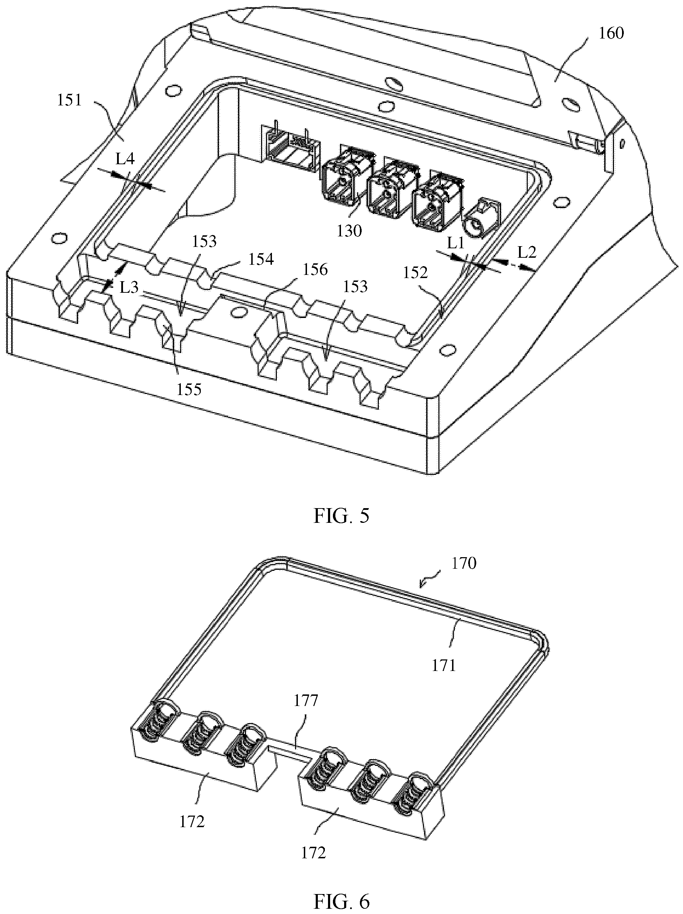

FIG. 5 is a partial schematic diagram of a structure of a second chamber frame according to an embodiment of this application. As shown in FIG. 5, a first groove 152 is disposed on a first frame top surface 151, and a first groove 152 is disposed in an annular manner around a second chamber 120 on the first frame top surface 151. A distance L1 between the first groove 152 and an inner wall of a second chamber frame 150 is less than a distance L2 between the first groove 152 and an outer wall of the second chamber frame 150. The inner wall of the second chamber frame 150 is a wall that is of the second chamber frame 150 and that faces the second chamber 120, and the outer wall of the second chamber frame 150 is a wall that is of the second chamber frame 150 and that faces outside of a housing.

At least one second groove 153 is further disposed on the first frame top surface 151. The second groove 153 is disposed in any position on a path of the first groove 152 and communicates with the first groove 152. In a preferred implementation, the second groove 153 may be disposed on the first frame top surface 151 on an opposite side of the connector 130. A depth of the second groove 153 in a direction perpendicular to a second chamber bottom surface 140 is greater than a depth of the first groove 152 in the direction perpendicular to the second chamber bottom surface 140, and a width L3 of the second groove 153 in a width direction of the first frame top surface 151 is greater than a width L4 of the first groove 152 in the width direction of the first frame top surface 151. When a plurality of second grooves 153 are disposed on the first frame top surface 151, the plurality of second grooves 153 may be disposed at intervals along a path direction of the first groove 152, and two adjacent second grooves 153 communicate with each other by using a first connection groove 156. For example, the first frame top surface 151 shown in FIG. 5 includes two second grooves 153.

The electronic device provided in this embodiment of this application further includes a first sealing rubber strip 170. The first sealing rubber strip 170 is configured to be installed in the first groove 152 and the second groove 153 in an embedded manner. FIG. 6 is a schematic diagram of a structure of a first sealing rubber strip 170 according to an embodiment of this application. With reference to FIG. 5 and FIG. 6, the first sealing rubber strip 170 has an annular structure that matches shapes and sizes of the first groove 152 and the second groove 153. Specifically, the first sealing rubber strip 170 may include a housing sealing part 171 and a first cable sealing part 172. The housing sealing part 171 has a structure that matches a shape and a size of the first groove 152, and may be embedded into the first groove 152. The first cable sealing part 172 has a structure that matches a shape and a size of the second groove 153, and may be embedded into the second groove 153.

In this embodiment of this application, when a plurality of second grooves 153 are disposed on a first frame top surface 151, the first sealing rubber strip 170 may include a plurality of first cable sealing parts 172 whose quantity is equal to a quantity of the second grooves 153, and two adjacent first cable sealing parts 172 are connected by using a first connection part 177. In this way, the plurality of first cable sealing parts 172 may be separately embedded into each second groove 153, and the first connection part 177 may be embedded into a first connection groove 156 (refer to FIG. 5). For example, the first frame top surface 151 shown in FIG. 6 includes two second grooves 153; and correspondingly, the first sealing rubber strip 170 includes two first cable sealing parts 172.

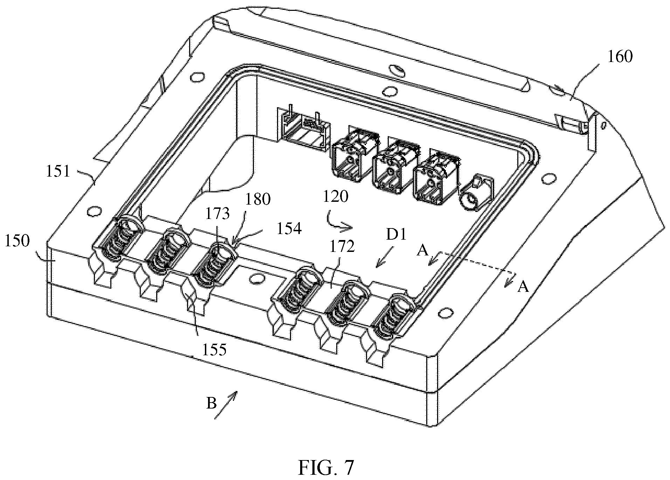

FIG. 7 is a schematic diagram of installing a first groove 152 and a first sealing rubber strip 170 according to an embodiment of this application. With reference to FIG. 5 and FIG. 7, after the first sealing rubber strip 170 is embedded into a first groove 152, at least one lower cable channel 180 used to lead out an external cable is formed on a first frame top surface 151 and a surface that is of a first cable sealing part 172 and that faces a protective cover 160, and a lower cable channel 180 passes through a second chamber 120 to outside of a housing. Each lower cable channel 180 sequentially includes, along a lead-out direction D1 of an external cable, a first internal cable outlet 154 disposed on the first frame top surface 151, a first cable trough 173 disposed on the first cable sealing part 172, and a first external cable outlet 155 disposed on the first frame top surface 151; and the first internal cable outlet 154, the first cable trough 173, and the first external cable outlet 155 are located on a same axis. The first internal cable outlet 154 extends from an inner wall of a second chamber frame 150 to the second groove 153, and the second chamber 120 communicates with the second groove 153. A depth of the first internal cable outlet 154 in a direction perpendicular to the first frame top surface 151 is less than a depth of the second groove 153 in the direction perpendicular to the first frame top surface 151. The first external cable outlet 155 extends from the first groove 152 to an outer wall of the second chamber frame 150, and the first groove 152 communicates with outside of the housing. A depth of the first external cable outlet 155 in the direction perpendicular to the first frame top surface 151 is less than a depth of the second groove 153 in the direction perpendicular to the first frame top surface 151. The first cable trough 173 is disposed on a surface that is of the first cable sealing part 172 and that faces the protective cover 160, and extends from the first internal cable outlet 154 to the first external cable outlet 155.

When the electronic device includes a plurality of lower cable channels 180, the plurality of lower cable channels 180 are disposed in parallel at intervals on the second chamber frame 150 and the first cable sealing part 172 along a length direction of the first sealing rubber strip 170. It may be understood that, when the electronic device includes a plurality of lower cable channels 180, and the first sealing rubber strip 170 includes a plurality of first cable sealing parts 172, at least one first cable trough 173 may be disposed in parallel on each first cable sealing part 172. For example, in a structure shown in FIG. 7, the electronic device includes six lower cable channels 180, and the first sealing rubber strip 170 includes two first cable sealing parts 172. In this case, three first cable troughs 173 may be disposed on each first cable sealing part 172.

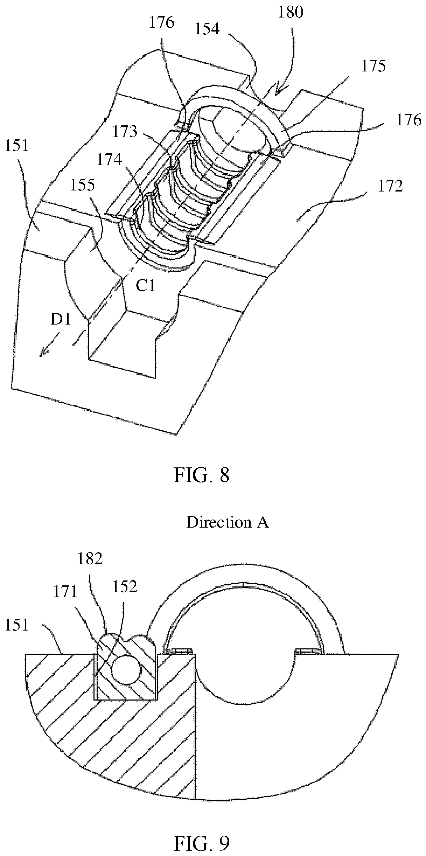

FIG. 8 is a partial enlarged schematic diagram of a lower cable channel according to an embodiment of this application. As shown in FIG. 8, in an optional implementation, a groove surface of a first cable trough 173 is a semi-cylindrical surface. At least one first groove rib 174 may be further disposed on the groove surface of the first cable trough 173, and the first groove rib 174 is perpendicular to a lead-out direction D1 of an external cable. When there are a plurality of first groove ribs 174, the plurality of first groove ribs 174 are disposed in parallel at intervals along the lead-out direction D1 of the external cable.

In an optional implementation, a sealing ring 175 is further disposed on an end that is of each first cable trough 173 and that is close to a first internal cable outlet 154; and a central axis of the sealing ring 175 is perpendicular to the lead-out direction D1 of the external cable, and an inner radius of the sealing ring 175 is preferably greater than a radius of a semi-cylindrical surface of the first cable trough 173.

In an optional implementation, the first cable sealing part 172 further includes first protruding parts 176. The first protruding parts 176 are disposed on a surface that is of the first cable sealing part 172 and that faces the protective cover 160. The first protruding parts 176 are symmetrically distributed on two sides of the first cable trough 173 with an axis C1 of the first cable trough 173 as a symmetry axis. Therefore, each first cable trough 173 corresponds to two first protruding parts 176. Each first protruding part 176 extends from one end of the first cable sealing part 172 to the other end of the first cable sealing part along the lead-out direction D1 of the external cable. The first protruding part 176 has a specific height in a direction perpendicular to a first frame top surface 151, and the height gradually decreases in a direction away from the axis C1 of the first cable trough 173, to form a slope structure.

FIG. 9 is an A-direction sectional view after a first groove and a first sealing rubber strip are installed according to an embodiment of this application. As shown in FIG. 9, in a preferred implementation, the first groove 152 may be a rectangular groove; and a width of a housing sealing part 171 is less than or equal to a width of the first groove 152, and the housing sealing part 171 and the first groove 152 form a clearance fit; and a height of the housing sealing part 171 is greater than a height of the first groove 152. In this way, a part of the housing sealing part 171 may be embedded into the first groove 152, and the other part is higher than the first frame top surface 151 and is located outside the first groove 152. To match a structure of the first groove 152, a cross-sectional shape of a part that is of the housing sealing part 171 and that is located in the first groove 152 may also be rectangular. A part that is of the housing sealing part 171 and that is located outside the first groove 152 may include two arc-shaped structures 182 that protrude toward the protective cover 160 (refer to FIG. 7), and the two arc-shaped structures 182 are disposed in parallel along a width direction of the housing sealing part 171.

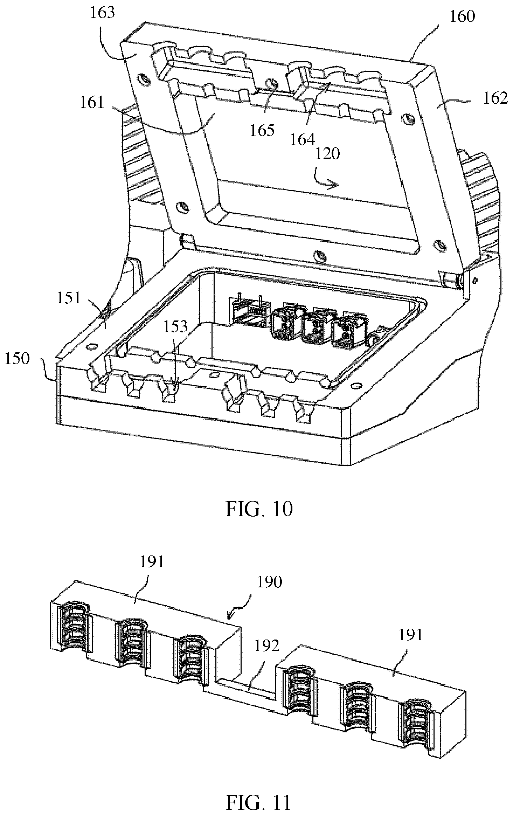

FIG. 10 is a schematic diagram of a structure of a protective cover 160 according to an embodiment of this application. As shown in FIG. 10, the protective cover 160 includes a protective cover top surface 161 and a protective cover frame 162. A shape and a size of the protective cover top surface 161 match a shape and a size of the bottom surface 140 of the second chamber (refer to FIG. 4), the protective cover frame 162 is disposed around the protective cover top surface 161, and the protective cover frame 162 has a specific height in a direction perpendicular to the protective cover top surface 161, to form another part of the depth of the second chamber 120. The protective cover frame 162 has a specific width in a direction parallel to the top surface 161 of the protective cover, and the width is preferably equal to a width of a second chamber frame 150. Therefore, the protective cover frame 162 can form, in a direction facing a first frame top surface 151, a second frame top surface 163 that matches a shape and a size of the first frame top surface 151.

In this embodiment of this application, the protective cover 160 may be connected to a housing 100 by using a hole shaft, a hinge, or the like, so that the protective cover 160 can flip relative to the housing 100 along a rotation axis, to implement fastening and opening between the protective cover 160 and the housing 100. When the protective cover 160 and the housing 100 are fastened, the first frame top surface 151 and the second frame top surface 163 are interconnected and attached to each other.

Further, as shown in FIG. 10, at least one third groove 164 is further disposed on the second frame top surface 163, a quantity of the third grooves 164 is equal to a quantity of the second grooves 153, and locations of the third grooves 164 and the second grooves 153 are in a one-to-one correspondence. A shape and a size of the third groove 164 match a shape and a size of the second groove 153. When the second frame top surface 163 includes a plurality of third grooves 164, two adjacent third grooves 164 communicate with each other by using the second connection groove 165.

The electronic device provided in this embodiment of this application further includes a second sealing rubber strip 190. The second sealing rubber strip 190 is configured to be embedded into the third groove 164. FIG. 11 is a schematic diagram of a structure of a second sealing rubber strip 190 according to an embodiment of this application. As shown in FIG. 11, the second sealing rubber strip 190 includes at least one second cable sealing part 191 that matches a shape of the third groove 164. A quantity of the second cable sealing parts 191 is equal to a quantity of the third grooves 164, and locations of the second cable sealing parts 191 and the third grooves 164 are in a one-to-one correspondence. In this way, each second cable sealing part 191 may be embedded into one third groove 164. In addition, when the second sealing rubber strip 190 includes a plurality of second cable sealing parts 191, a second connection part 192 may be further included between two adjacent second cable sealing parts 191. The second connection part 192 is configured to connect the plurality of second cable sealing parts 191 to form an integrated structure. The second connection part 192 matches a location and a size of the second connection groove 165, and can be embedded into the second connection groove 165.

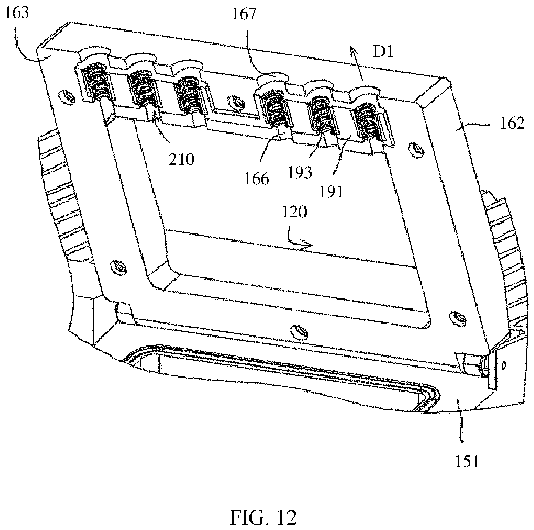

FIG. 12 is a schematic diagram of installing a third groove 164 and a second sealing rubber strip 190 according to an embodiment of this application. As shown in FIG. 12, after the second sealing rubber strip 190 is embedded into the third groove 164, a second frame top surface 163 and a surface that is of a second cable sealing part 191 and that faces a first frame top surface 151 form at least one upper cable channel 210 for leading out an external cable. An upper cable channel 210 penetrates from the second chamber 120 to outside of a housing. A quantity of the upper cable channels 210 is equal to a quantity of the lower cable channels 180 (refer to FIG. 7), and locations of the upper cable channels 210 and the lower cable channels 180 are in a one-to-to-one correspondence. Each upper cable channel 210 sequentially includes, along a lead-out direction D1 of the external cable, a second internal cable outlet 166 disposed on the second frame top surface 163, a second cable trough 193 disposed on the second cable sealing part 191, and a second external cable outlet 167 disposed on the second frame top surface 163; and the second internal cable outlet 166, the second cable trough 193, and the second external cable outlet 167 are located on a same axis. The second internal cable outlet 166 extends from an inner wall of a protective cover frame 162 to the third groove 164, and the second chamber 120 communicates with the third groove 164. A depth of the second internal cable outlet 166 in a direction perpendicular to the second frame top surface 163 is less than a width of the third groove 164 in the direction perpendicular to the second frame top surface 163. The second external cable outlet 167 extends from an outer wall of the protective cover frame 162 to the third groove 164, and the third groove 164 communicates with outside of the housing. A depth of the second external cable outlet 167 in a direction perpendicular to a top surface of the protective cover frame 162 is less than a depth of the third groove 164 in a direction perpendicular to the second frame top surface 163. The second cable trough 193 is disposed on a surface that is of the second cable sealing part 191 and that faces a second chamber frame 150, and extends from a side close to the second internal cable outlet 166 to a side close to the second external cable outlet 167.

Further, as shown in FIG. 12, when the electronic device includes a plurality of upper cable channels 210, the plurality of upper cable channels 210 are disposed in parallel at intervals on the protective cover frame 162 and the second cable sealing part 191. It may be understood that when the electronic device includes a plurality of upper cable channels 210, and each second sealing rubber strip 190 includes a plurality of second cable sealing parts 191, at least one second cable trough 193 may be disposed in parallel on each second cable sealing part 191. For example, in a structure shown in FIG. 12, the electronic device includes six upper cable channels 210, and the second sealing rubber strip 190 includes two second cable sealing parts 191. In this case, three second cable troughs 193 may be disposed on each second cable sealing part 191.

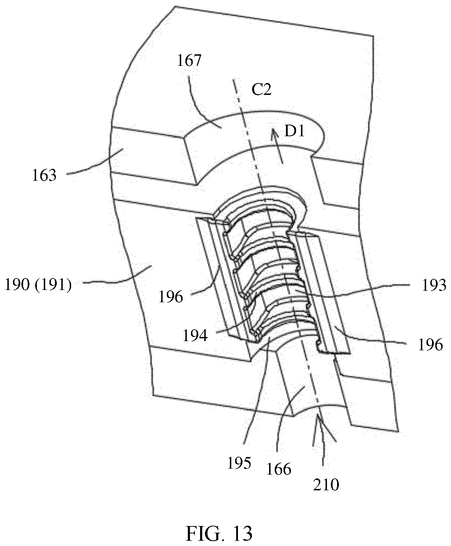

FIG. 13 is a partial enlarged schematic diagram of an upper cable channel according to an embodiment of this application. As shown in FIG. 13, in an optional implementation, a groove surface of a second cable trough 193 is a semi-cylindrical surface. At least one second groove rib 194 may be further disposed on the groove surface of the second cable trough 193, and a second groove rib 194 is perpendicular to a lead-out direction D 1 of an external cable. When there are a plurality of second groove ribs 194, the plurality of second groove ribs 194 are disposed in parallel at intervals along the lead-out direction D1 of the external cable.

In an optional implementation, an annular groove 195 corresponding to a sealing ring 175 of a first cable trough 173 is further disposed at one end that is of each second cable trough 193 and that is close to a second internal cable outlet 166; and a radius of the annular groove 195 is preferably greater than a radius of a groove surface of a semi-cylindrical surface of the second cable trough 193, and is preferably less than or equal to an outer radius of the sealing ring 175 of the first cable trough 173 (refer to FIG. 8).

In an optional implementation, a thickness of a second sealing rubber strip 190 in a direction perpendicular to a second frame top surface 163 is greater than a depth of a third groove 164 in a direction perpendicular to the second frame top surface 163, so that the second sealing rubber strip 190 protrudes from the second frame top surface 163.

In an optional implementation, a second cable sealing part 191 further includes second protruding parts 196, the second protruding parts 196 are disposed on a side that is of the second cable sealing part 191 and that faces a first frame top surface 151 (refer to FIG. 12), and the second protruding parts 196 are symmetrically distributed on two sides of the second cable trough 193 with an axis C2 of the second cable trough 193 as a symmetric axis. Therefore, each second cable trough 193 corresponds to two second protruding parts 196, and the second protruding parts 196 are in a one-to-one correspondence with first protruding parts 176 disposed on a first cable sealing part 172. Each second protruding part 196 extends, along the lead-out direction D1 of the external cable, from the second groove rib 194 closest to the second internal cable outlet 166 to the second groove rib 194 closest to the second external cable outlet 167. The second protruding part 196 has a specific height in a direction perpendicular to the second frame top surface 163, and the height gradually decreases in a direction away from the axis C2 of the second cable trough 193, to form a slope structure.

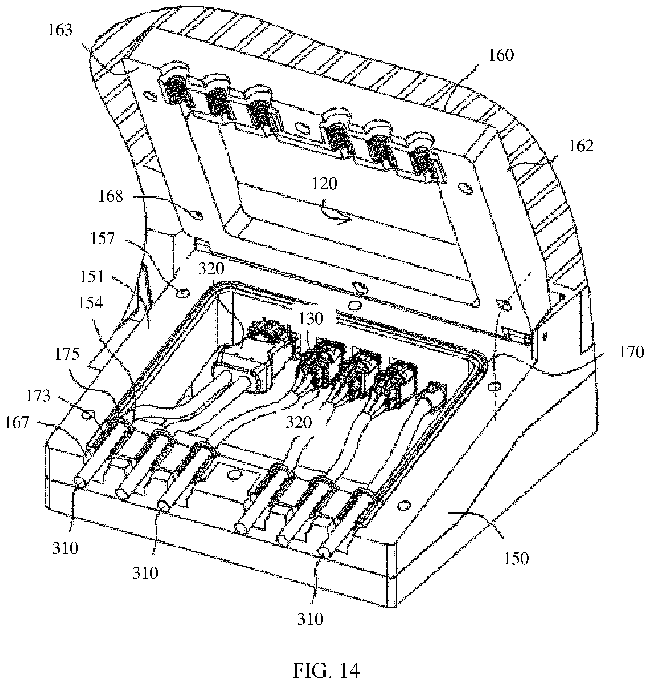

FIG. 14 is a schematic diagram of connection between an electronic device and an external cable according to an embodiment of this application. As shown in FIG. 14, the external cable includes a cable body 310 and a wiring terminal 320 disposed at one end of the cable body 310. The wiring terminal 320 is disposed in a second chamber 120 and inserted into a connector 130. The cable body 310 sequentially passes through a first internal cable outlet 154, a sealing ring 175, a first cable trough 173, and a second external cable outlet 167 from inside of the second chamber 120, so as to extend to outside of the electronic device.

Further, as shown in FIG. 14, a second chamber frame 150 includes a plurality of first positioning holes 157. The plurality of first positioning holes 157 are disposed on a first frame top surface 151 at intervals, and form a specific depth inside the second chamber frame 150. The first positioning holes 157 are preferably blind holes. In a preferred implementation, each first positioning hole 157 is disposed between the first sealing rubber strip 170 and an outer wall of the second chamber frame 150, the protective cover frame 162 further includes a plurality of second positioning holes 168, the plurality of second positioning holes 168 are disposed on the second frame top surface 163 at intervals, and the second positioning holes 168 are through holes. When a protective cover 160 is fastened, the plurality of second positioning holes 168 are coaxially distributed in a one-to-one correspondence with the plurality of first positioning holes 157. In this way, as shown in FIG. 14, after the protective cover 160 is fastened, a screw may be screwed into the second positioning hole 168 and the first positioning hole 157, so that the protective cover 160 and a housing are fastened and locked through a threaded connection.

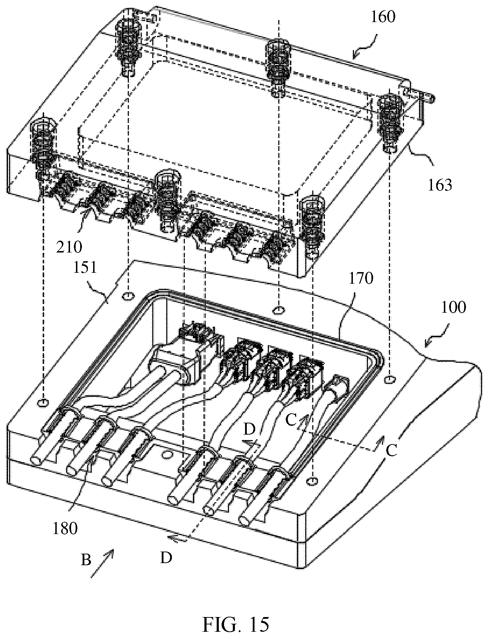

FIG. 15 is a schematic diagram of a fitting relationship between a housing 100, a protective cover 160, and a first sealing rubber strip 170 when the protective cover 160 is fastened. As shown in FIG. 15, when the protective cover 160 is fastened, a first frame top surface 151 can be closely attached to a second frame top surface 163. At least one lower cable channel 180 located on the first frame top surface 151 and at least one upper cable channel 210 located on the second frame top surface 163 are interconnected in a one-to-one correspondence, to form at least one complete cable channel.

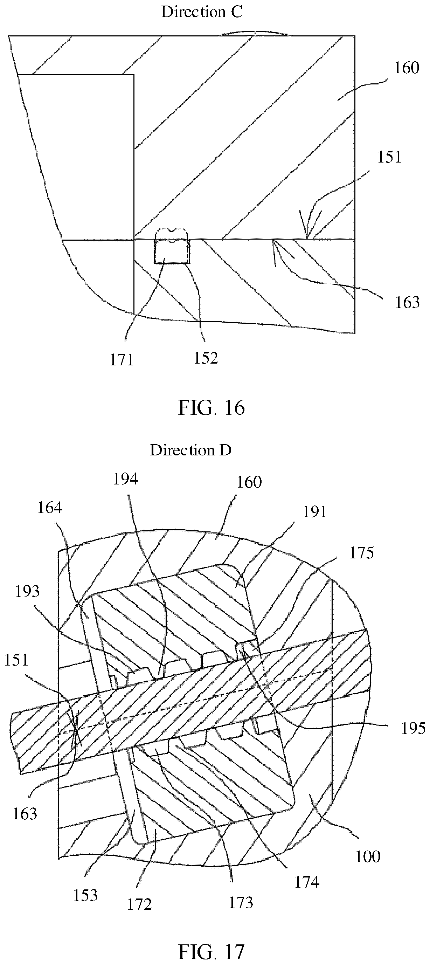

FIG. 16 is a diagram of a fitting relationship between a housing sealing part 171 of a first sealing rubber strip, a first frame top surface 151, and a second frame top surface 163. As shown in FIG. 16, when the protective cover is fastened, because the housing sealing part 171 is higher than the first frame top surface 151, the housing sealing part 171 is squeezed by the second frame top surface 163 and deformed. The deformed housing sealing part 171 produces a specific pressure on an inner wall of the first groove 152 and the second frame top surface 163 that are in contact with the housing sealing part 171, so that the housing sealing part 171 is closely attached to the inner wall of the first groove 152 and the second frame top surface 163, to from sealing, so as to prevent liquid and dust from entering a housing from outside of the housing. Further, because the housing sealing part 171 includes two arc-shaped structures that protrude toward the protective cover 160, when the protective cover 160 is fastened, the two arc-shaped structures may be in close contact with the second frame top surface 163, so that two-layer sealing is formed between the housing sealing part 171 and the protective cover 160, thereby improving waterproof and dustproof effects.

FIG. 17 is a diagram of a fitting relationship between a cable, a first cable sealing part 172, and a second cable sealing part 191 when the protective cover 160 is fastened. As shown in FIG. 17, when the protective cover 160 is fastened, a first frame top surface 151 is closely attached to a second frame top surface 163. In this case, the first cable sealing part 172 and the second cable sealing part 191 will squeeze each other to produce deformation, and a pressure produced by the deformation enables the first cable sealing part 172 and the second cable sealing part 191 to be closely attached to from sealing, so as to prevent liquid and dust from entering a housing from a junction between the first cable sealing part 172 and the second cable sealing part 191.

Further, with reference to FIG. 17, when the protective cover 160 is fastened, a first cable trough 173 of the first cable sealing part 172 and a second cable trough 193 of the second cable sealing part 191 are interconnected, and after the interconnection, semi-cylindrical groove surfaces of the first cable trough 173 and the second cable trough 193 can form a complete cylindrical groove surface for accommodating a cable. On this basis, a quantity of at least one first groove rib 174 disposed in the first cable trough 173 is equal to a quantity of at least one second groove rib 194 disposed in the second cable trough 193, and the at least one first groove rib 174 and the at least one second groove rib 194 are in a one-to-one correspondence. Each group of the first groove rib 174 and the second groove rib 194 that have a correspondence are preferably located in a same plane, and a cable body 310 is pressed tightly from two directions, that is, an up direction and a down direction, to form sealing, so as to prevent liquid and dust from entering a housing from the cable body 310, the first cable trough 173, and the second cable trough 193.

It may be understood that, when there are a plurality of first groove ribs 174 and a plurality of second groove ribs 194 that are in a one-to-one correspondence, each group of the first groove rib 174 and the second groove ribs 194 that have a correspondence form sealing. Therefore, multi-layer sealing may be formed between a cable and the first cable trough 173 and between the cable and the second cable trough 193, thereby enhancing a capability of preventing liquid and dust from entering the housing from the cable, the first cable trough 173, and the second cable trough 193.

Further, as shown in FIG. 17, when the protective cover 160 is fastened, a sealing ring 175 of the first cable sealing part 172 can be embedded into an annular groove 195 of the second cable sealing part 191, and the sealing ring 175 can be tightly attached to the annular groove 195 under pressure between the first cable sealing part 172 and the second cable sealing part 191, to from sealing, so as to prevent liquid and dust from entering the housing from the first cable sealing part 172 and the second cable sealing part 191.

In addition, it may be understood that, under pressure of the first cable sealing part 172 and the second cable sealing part 191, the deformed first cable sealing part 172 produces a specific pressure on a bottom surface and a side surface of a second groove 153, so that the first cable sealing part 172 is in close contact with the bottom surface and the side surface of the second groove 153, to from sealing, so as to prevent liquid and dust from entering the housing from the first cable sealing part 172 and the protective cover 160. Similarly, the deformed second cable sealing part 191 produces a specific pressure on a bottom surface and a side surface of a third groove 164, so that the second cable sealing part 191 is in close contact with the bottom surface and the side surface of the third groove 164, to from sealing, so as to prevent liquid and dust from entering the housing from the second cable sealing part 191 and the housing 100.

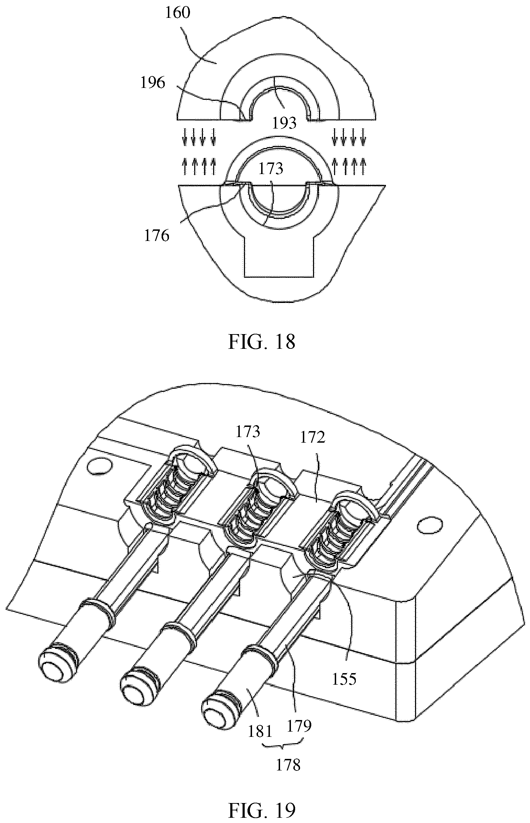

FIG. 18 is a schematic diagram of fitting between a first protruding part 176 and a second protruding part 196. As shown in FIG. 18, when the protective cover 160 is fastened, each group of the first protruding part 176 and the second protruding part 196 that are on two sides of the first cable trough 173 and the second cable trough 193 and that have a correspondence are in contact with each other and squeeze each other, to produce deformation. In this way, a relatively high pressure is produced between the first protruding part 176 and the second protruding part 196, so that the first protruding part 176 and the second protruding part 196 are closely attached, thereby improving a sealing effect at a junction of the first cable trough 173 and the second cable trough 193.

It can be learned from the foregoing technical solution that, in the electronic device provided in this embodiment of this application, the protective cover that can be opened and fastened is disposed on the housing. In the electronic device, a connector that does not have waterproof performance is disposed inside the housing, and an external cable is connected to the connector inside the housing, and then is led out from the housing to outside of the housing. For ease of leading out a cable, at least one cable channel is provided on a fastening surface of the housing and the protective cover, and housing sealing components such as a first sealing rubber strip and a second sealing rubber strip are further disposed around a cable outlet. When the protective cover is fastened, the housing and the protective cover can press the first sealing rubber strip tightly, to form sealing between the housing and the protective cover. In addition, the first sealing rubber strip and the second sealing rubber strip can press a cable tightly, to form sealing between the cable and the housing and between the cable and the protective cover. In this way, liquid, dust, and the like outside the housing will not enter the housing, so that the electronic device can also have a waterproof capability and a dustproof capability when using a connector that does not have waterproof performance.

FIG. 19 is a schematic diagram of a structure of another first sealing rubber strip according to an embodiment of this application. As shown in FIG. 19, a first sealing rubber strip 170 further includes at least one cable channel sealing part 178. A quantity of the cable channel sealing parts 178 depends on a quantity of first cable troughs 173 disposed on the first sealing rubber strip 170, and is generally less than or equal to the quantity of the first cable troughs 173. When the quantity of the cable channel sealing parts 178 is equal to the quantity of the first cable troughs 173, it means that each cable channel sealing part 178 is provided with one corresponding first cable trough 173; or when the quantity of the cable channel sealing parts 178 is less than the quantity of the first cable troughs 173, only some of the first cable troughs 173 are provided with corresponding cable channel sealing parts 178. Each cable channel sealing part 178 includes an extension rubber strip 179 and a sealing rubber plug 181. One end of the extension rubber strip 179 is disposed on a side that is of a first cable sealing part 172 and that faces a first external cable outlet 155, and the other end extends through a first external cable outlet 155 to outside of a housing. The sealing rubber plug 181 is of a cylindrical structure, and a circular bottom surface of the sealing rubber plug 181 is connected to one end that is of the extension rubber strip 179 and that is located outside the housing.

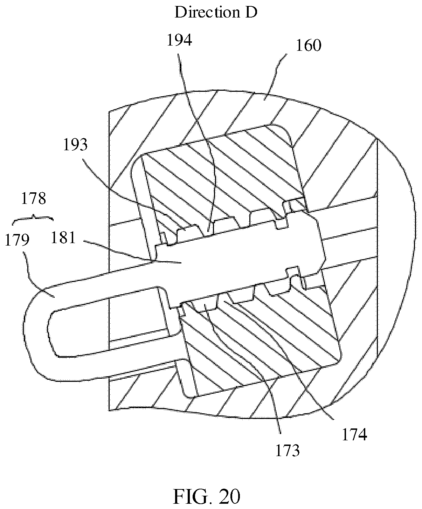

FIG. 20 is a schematic diagram of a manner of using a cable channel sealing part 178 according to an embodiment of this application. As shown in FIG. 20, when a quantity of cables led out from a housing is less than a quantity of cable channels, the cable channel sealing part 178 may be used to seal a cable channel in which no cable is led out, so as to maintain a waterproof and dustproof capability of an electronic device. During specific implementation, before a protective cover 160 is fastened, an extension rubber strip 179 may be bent toward a housing, so as to place a sealing rubber plug 181 in a first cable trough 173, and then fasten the protective cover 160. In this way, a first groove rib 174 of the first cable trough 173 and a second groove rib 194 of a second cable trough 193 may press the sealing rubber plug 181 in two opposite directions, that is, an up direction and a down direction, to from sealing, so as to prevent liquid and dust from entering the housing from the cable channel. In this case, a role of the sealing rubber plug 181 is equivalent to a cable.

The following further describes a structure of a housing according to an embodiment of this application with reference to more accompanying drawings.

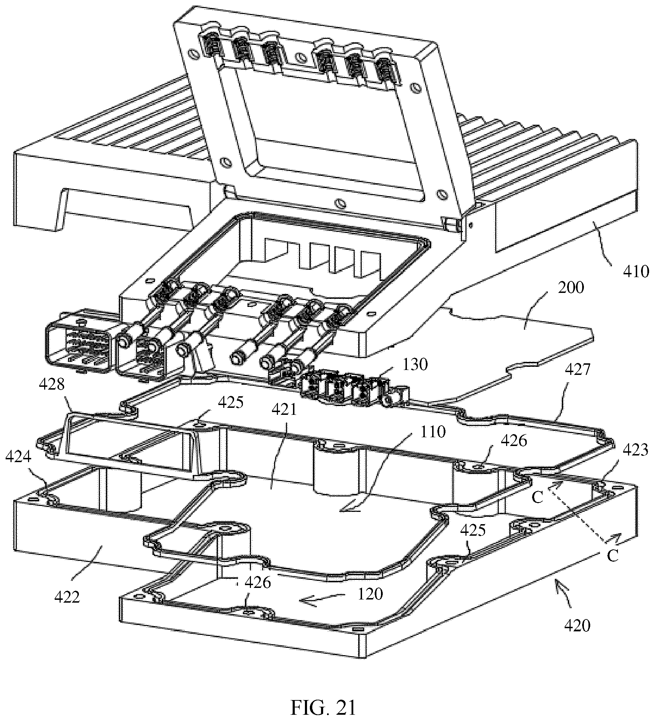

FIG. 21 is a schematic exploded view of a structure of a housing according to an embodiment of this application. As shown in FIG. 21, a housing 100 may include an upper housing 410 and a lower housing 420, and the upper housing 410 and the lower housing 420 are fastened from two directions, that is an up direction and a down direction, to form a first chamber 110 and a second chamber 120. The lower housing 420 includes a lower housing bottom surface 421 and a lower housing frame 422 disposed around an edge of the lower housing bottom surface 421. The lower housing frame 422 has a specific height in a direction perpendicular to the lower housing bottom surface 421, to form a lower half part of the first chamber 110 and a lower half part of the second chamber 120 in the direction perpendicular to the lower housing bottom surface 421. The lower housing bottom surface 421 may include a bottom surface area used to form the first chamber 110 and a bottom surface area used to form the second chamber 120. In this embodiment of this application, the first chamber 110 and the second chamber 120 may be designed to be in any shape according to a requirement. Therefore, neither a shape nor a size of the lower housing bottom surface 421 is limited in this embodiment of this application.

Further, as shown in FIG. 21, the lower housing frame 422 has a specific width in the direction parallel to the lower housing bottom surface 421, so as to form a fourth frame top surface 423 on a side facing the upper housing 410. Consecutive fourth grooves 424 are disposed on the fourth frame top surface 423. Further, the lower housing frame 422 further includes a plurality of first screw hole supports 425, the plurality of first screw hole supports 425 are disposed on an inner side of the lower housing frame 422 at intervals, and a width of each first screw hole support 425 is greater than a width of the lower housing frame 422.

In an optional implementation, the first screw hole support 425 may be an arc-shaped structure protruding from the lower housing frame 422. When passing through the first screw hole support 425, the fourth groove 424 may be offset to an inner side of the lower housing frame 422 to adapt to a contour of the first screw hole support 425. In this way, the first screw hole support 425 forms a flat area with a relatively large area between the fourth groove 424 and an outer side of the lower housing frame 422. Further, the lower housing frame 422 is further provided with a plurality of third positioning holes 426. The plurality of third positioning holes 426 are distributed on the first screw hole supports 425 at intervals, and are preferably disposed in the flat area between the fourth groove 424 and the outer side of the lower housing frame 422. The third positioning holes 426 are through holes and run through the lower housing frame 422 in the direction perpendicular to the lower housing bottom surface 421.

Further, as shown in FIG. 21, the electronic device provided in this embodiment of this application further includes a third sealing rubber strip 427. The third sealing rubber strip 427 has an annular structure that matches a shape and a size of the fourth groove 424, and can be embedded into the fourth groove 424. A thickness of the third sealing rubber strip 427 in a direction perpendicular to the fourth frame top surface 423 is greater than a depth of the fourth groove 424. In this way, after the third sealing rubber strip 427 is embedded, the third sealing rubber strip 427 may be higher than the fourth frame top surface 423. Further, in a direction that is of a housing sealing part 171 of a first sealing rubber strip 170 and that faces an upper housing 410, there may be two arc-shaped structures that protrude toward the a protective cover 160, and the two arc-shaped structures are disposed in parallel along a width direction of the third sealing rubber strip 427.

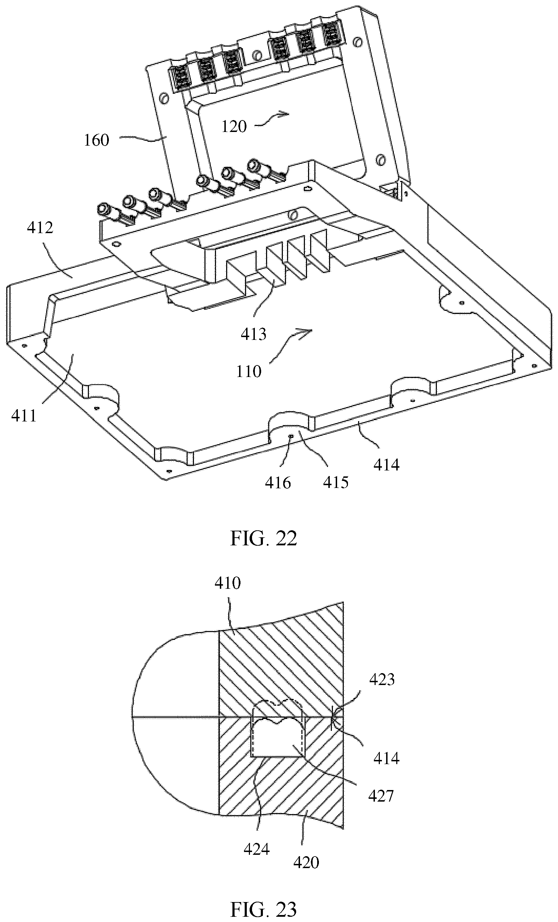

FIG. 22 is a schematic diagram of a structure of an upper housing 410 according to an embodiment of this application. As shown in FIG. 22, the upper housing 410 includes an upper housing top surface 411, an upper housing frame 412, and a protective cover 160. A part of the upper housing frame 412 and the upper housing top surface 411 jointly enclose an upper part of the first chamber 110; and the other part of the upper housing frame 412 and the protective cover 160 jointly enclose an upper part of a second chamber 120. Apart that is of the upper housing frame 412 and that is used to enclose the second chamber 120 is corresponding to the second chamber frame 150 described in the foregoing embodiments of this application.

Further, as shown in FIG. 22, at least one positioning groove 413 is disposed on the upper housing 410 at an adjacent position between the first chamber 110 and the second chamber 120, and the positioning groove 413 extends from one side of the first chamber 110 to one side of the second chamber 120. When there are a plurality of positioning grooves 413, the plurality of positioning grooves 413 are disposed in parallel at intervals. In this embodiment of this application, a connector 130 (refer to FIG. 21) led out from a device mainboard 200 is disposed in a positioning groove 413. Therefore, the positioning groove 413 is used to limit the connector 130 and isolate a plurality of connectors 130 from each other. In this embodiment of this application, one connector 130 is preferably disposed in each positioning groove 413. Therefore, a quantity of positioning grooves 413 is greater than or equal to a quantity of connectors 130 that need to be waterproofed.

Further, as shown in FIG. 22, a part that is of the upper housing frame 412 and that is used to enclose the first chamber 110 has a specific width in a direction parallel to the upper housing top surface 411. Therefore, a fifth frame top surface 414 that is used to be interconnected with the fourth frame top surface 423 (refer to FIG. 21) is formed on a side facing a lower housing 420 (refer to FIG. 21). A width of the fifth frame top surface 414 is preferably the same as a width of the fourth frame top surface 423. Further, the upper housing frame 412 further includes a plurality of second screw hole supports 415 that are in a one-to-one correspondence with first screw hole supports 425 (refer to FIG. 21), the plurality of second screw hole supports 415 are disposed on an inner side of the upper housing frame 412 at intervals, and a width of each first screw hole support 425 is greater than a width of the upper housing frame 412.

In an optional implementation, the second screw hole support 415 may be an arc-shaped structure protruding from the upper housing frame 412, and a size and a shape of the second screw hole support 415 are respectively the same as a size and a shape of the first screw hole support 425. Further, a plurality of fourth positioning holes 416 are further disposed on the upper housing frame 412, and the plurality of fourth positioning holes 416 are distributed on the second screw hole supports 415 at intervals, and are coaxially disposed in a one-to-one correspondence with the plurality of third positioning holes 426. The fourth positioning holes 416 are preferably blind holes.

FIG. 23 is a schematic diagram of installing an upper housing 410 and a lower housing 420 according to an embodiment of this application. As shown in FIG. 23, when the upper housing 410 and the lower housing 420 are fastened, because a third sealing rubber strip 427 is higher than a fourth frame top surface 423, the third sealing rubber strip 427 is squeezed by a fifth frame top surface 414 and deformed. The deformed third sealing rubber strip 427 produces a specific pressure on an inner wall of a fourth groove 424 and the fifth frame top surface 414 that are in contact with the third sealing rubber strip 427, so that the third sealing rubber strip 427 is closely attached to the inner wall of the fourth groove 424 and the fifth frame top surface 414, to form sealing, so as to prevent liquid and dust from entering a housing from outside of the housing. Further, because the third sealing rubber strip 427 includes two arc-shaped structures that protrude toward the fifth frame top surface 414, when the upper housing 410 and the lower housing 420 are fastened, the two arc-shaped structures may be in close contact with the fifth frame top surface 414, so that two-layer sealing is formed between the third sealing rubber strip 427 and the fifth frame top surface 414, thereby improving waterproof and dustproof effects.

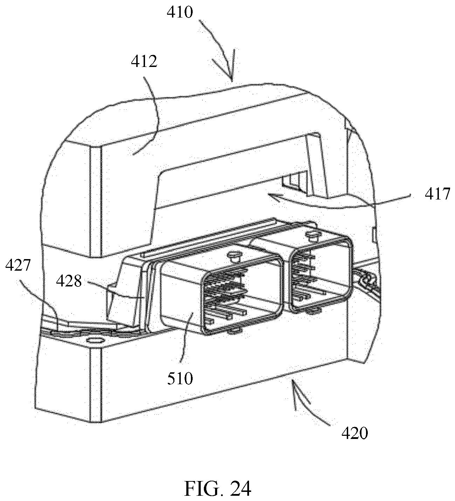

In an implementation, the electronic device may further include at least one connector 510 having a waterproof capability, for example, a low-speed connector. For ease of disposing the connector 510, as shown in FIG. 24, an upper housing frame 412 may be provided with a connector opening 417, and the connector 510 may be disposed in the connector opening 417. In addition, to facilitate waterproofing between the connector 510 and the upper housing 410 and between the connector 510 and the lower housing 420, the third sealing rubber strip 427 is further provided with an annular structure 428 (refer to FIG. 22) that matches a structure of the connector 510 in the connector opening 417; and the annular structure 428 is sleeved on the connector 510, and can be in contact with the upper housing frame 412 and the lower housing frame 422 after the upper housing 410 and the lower housing 420 are fastened, so as to implement waterproof and dustproof effects between the connector 510 and the upper housing 410 and between the connector 510 and the lower housing 420.

An embodiment of this application further provides a vehicle. The vehicle includes the electronic device according to any one of the foregoing embodiments of this application. The electronic device may include an in-vehicle computing module, for example, an automated driving computing platform, an ECU, or a VCU. The vehicle includes but is not limited to a fuel motor vehicle, a fuel-electric hybrid motor vehicle, a pure electric motor vehicle, an engineering machine having a driving capability, an automated guided vehicle AGV, a robot having a driving capability, and the like.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. An electronic device, comprising a housing (100) and a device mainboard (200), wherein
the housing (100) comprises a first chamber (110) and a second chamber (120), wherein the first chamber (110) and the second chamber (120) are disposed adjacently;
the device mainboard (200) is disposed in the first chamber (110), the device mainboard (200) is provided with a connector (510), and one end that is of the connector (510) and that is used to connect to an external cable extends from the first chamber (110) to the second chamber (120);
the housing (100) comprises a second chamber frame (150) and a protective cover (160), wherein the protective cover (160) is configured to be fastened on the second chamber frame (150);
the second chamber frame (150) is provided with a first sealing rubber strip (170); the protective cover (160) comprises a protective cover frame (162), and the protective cover frame (162) is provided with a second sealing rubber strip (190); and the first sealing rubber strip (170) and the second sealing rubber strip (190) are interconnected to form a cable channel used to lead out the external cable from the second chamber (120); and
when the protective cover (160) is fastened, the second chamber frame (150) and the protective cover frame (162) press the first sealing rubber strip (170) to implement waterproof sealing between the second chamber frame (150) and the protective cover frame (162), and the first sealing rubber strip (170) and the second sealing rubber strip (190) press the external cable in the cable channel to implement waterproof sealing between the external cable and the second chamber frame (150) and between the external cable and the protective cover frame (162).

2. The electronic device according to claim 1, wherein the second chamber frame (150) comprises a first frame top surface (151) facing the protective cover (160), the first frame top surface (151) is provided with a first groove (152) and a second groove (153), the first groove (152) is disposed around the second chamber (120) in an annular manner, and the second groove (153) is disposed on a path of the first groove (152) and communicates with the second groove (153).

3. The electronic device according to claim 2, wherein the first sealing rubber strip (170) is of an annular structure and comprises a first cable sealing part (172), and the first cable sealing part (172) matches a structure of the second groove (153) and is disposed in the second groove (153).

4. The electronic device according to claim 3, wherein the first sealing rubber strip (170) further comprises a housing sealing part (171), and the housing sealing part (171) matches a structure of the first groove (152) and is disposed in the first groove (152).

5. The electronic device according to claim 3 or 4, wherein the protective cover frame (162) comprises a second frame top surface (163) facing the second chamber frame (150), the second frame top surface (163) comprises a third groove (164), and the third groove (164) is disposed in correspondence with the second groove (153).

6. The electronic device according to claim 5, wherein the second sealing rubber strip (190) comprises a second cable sealing part (191) that is configured to be interconnected with the first cable sealing part (172), and the second cable sealing part (191) matches the structure of the second groove (153) and is disposed in the third groove (164).

7. The electronic device according to claim 6, wherein cable channels comprise a lower cable channel (180) and an upper cable channel (210) that are disposed through interconnection; the lower cable channel (180) is disposed on the first frame top surface (151) and a surface that is of the first cable sealing part (172) and that faces the protective cover (160); and the upper cable channel (210) is disposed on the second frame top surface (163) and a surface that is of the second cable sealing part (191) and that faces the second chamber frame (150).

8. The electronic device according to claim 7, wherein the lower cable channel (180) sequentially comprises a first internal cable outlet (154), a first cable trough (173), and a first external cable outlet (155) along a lead-out direction of the external cable; the first internal cable outlet (154) and the first external cable outlet (155) are disposed on the first frame top surface (151), the first internal cable outlet (154) extends from an inner wall of the second chamber frame (150) to the second groove (153), and the first external cable outlet (155) extends from the first groove (152) to an outer wall of the second chamber frame (150); and the first cable trough (173) is disposed on a surface that is of the first cable sealing part (172) and that faces the protective cover (160), and extends from the first internal cable outlet (154) to the first external cable outlet (155).

9. The electronic device according to claim 8, wherein the upper cable channel (210) sequentially comprises a second internal cable outlet (166), a second cable trough (193), and a second external cable outlet (167) along the lead-out direction of the external cable; the second internal cable outlet (166) and the second external cable outlet (167) are disposed on the second frame top surface (163), the second internal cable outlet (166) extends from an inner wall of the protective cover frame (162) to the third groove (164), and the second external cable outlet (167) extends from an outer wall of the protective cover frame (162) to the third groove (164); and the second cable trough (193) is disposed on a surface that is of the second cable sealing part (191) and that faces the second chamber frame (150), and extends from the second internal cable outlet (166) to the second external cable outlet (167).

10. The electronic device according to claim 9, wherein both a groove surface of the first cable trough (173) and a groove surface of the second cable trough (193) are semi-cylindrical surfaces.

11. The electronic device according to claim 9 or 10, wherein at least one first groove rib (174) is disposed on the groove surface of the first cable trough (173), at least one second groove rib (194) is disposed on the groove surface of the second cable trough (193), and the first cable trough (173) and the second groove rib (194) are perpendicular to the lead-out direction of the external cable; and a quantity of the first groove ribs (174) is equal to a quantity of the second groove ribs (194), the first groove ribs (174) and the second groove ribs (194) are disposed in a one-to-one correspondence, and the first groove rib (174) and the second groove rib (194) that have a correspondence are located in a same plane, and are configured to press the external cable from two directions, that is, an up direction and a down direction.

12. The electronic device according to any one of claims 9 to 11, wherein a sealing ring (175) for the cable to pass through is disposed at one end that is of the first cable trough (173) and that is close to the first internal cable outlet (154); and an annular groove (195) for embedding the sealing ring (175) is disposed at one end that is of the second cable trough (193) and that is close to the second internal cable outlet (166), and a radius of the annular groove (195) is less than or equal to an outer radius of the sealing ring (175).

13. The electronic device according to any one of claims 9 to 12, wherein the first cable sealing part (172) further comprises first protruding parts (176), and the first protruding parts (176) are located on a surface that is of the first cable sealing part (172) and that faces the protective cover (160), and are distributed on two sides of the first cable trough (173); and each first protruding part (176) extends from one end of the first cable sealing part (172) to the other end of the first cable sealing part (172) along the lead-out direction of the external cable.

14. The electronic device according to claim 13, wherein the second cable sealing part (191) further comprises second protruding parts (196), and the second protruding parts (196) are located on a surface that is of the second cable sealing part (191) and that faces the second chamber frame (150), distributed on two sides of the second cable trough (193), and are disposed in correspondence with the second protruding parts (196); and each second protruding part (196) extends from one end of the second cable sealing part (191) to the other end of the second cable sealing part (191) along the lead-out direction of the external cable.

15. The electronic device according to any one of claims 8 to 14, wherein the first sealing rubber strip (170) further comprises a cable channel sealing part (178); the cable channel sealing part (178) comprises an extension rubber strip (179) and a sealing rubber plug (181); one end of the extension rubber strip (179) is disposed on a side that is of the first cable sealing part (172) and that faces the first external cable outlet (155), and the other end passes through the first external cable outlet (155) and extends to outside of the housing (100); and the sealing rubber plug (181) is of a cylindrical structure, and a circular bottom surface of the sealing rubber plug (181) is connected to one end of the extension rubber strip (179) located outside the housing (100).

16. A vehicle, comprising the electronic device according to any one of claims 1 to 15.
